# EUROPEAN PATENT SPECIFICATION

(11) **EP 2 717 315 B1**
(45) Date of publication and mention of the grant of the patent: **02.01.2019**
(21) Application number: 13166248.8
(22) Date of filing: 02.05.2013
(51) Int. Cl.: H01L 29/786, H05K 1/09, H05K 3/06, H01L 29/45, H01L 27/12, H01L 29/49

(54) **Copper-based metal wiring comprising oxide layer including indium and zinc**
Kupferbasierte Metallverdrahtung mit einer Oxidschicht, die Indium und Zink enthält
Câblage métallique à base de cuivre avec une couche d'oxyde comprenant indium et zinc

(30) Priority: 05.10.2012 KR 20120110660
(43) Date of publication of application: 09.04.2014
(73) Proprietor: Samsung Display Co., Ltd., Gyeonggi-do (KR)
(72) Inventor: Park, Hong-Sick, Suwon-si, Gyeonggi-do 202-1003 (KR); Lee, Wang-Woo, Suwon-si, Gyeonggi-do B-307 (KR); Kim, Bong-Kyun, Hwaseong-si, Gyeonggi-do 304-1504 (KR); Choung, Jong-Hyun, Hwaseong-si, Gyeonggi-do 102-1301 (KR); Park, Young-Woo, Seongnam-si, Gyeonggi-do 110-201 (KR); Kim, Gyu-Po, Hwaseong-si, Gyeonggi-do (KR); Seo, Won-Guk, Hwaseong-si, Gyeonggi-do (KR); Shin, Hyun-Cheol, Suwon-si, Gyeonggi-do 108-1201 (KR); Han, Seung-Yeon, Hwaseong-si, Gyeonggi-do (KR); Lee, Ki-Beom, Gangnam-gu, Seoul 102-901 (KR); Cho, Sam-Young, Anyang-si, Gyeonggi-do 104-301 (KR)
(74) Representative: Dr. Weitzel & Partner

(56) References cited:
- EP-A1- 1 507 267
- EP-A1- 1 933 293
- US-A1- 2006 043 365
- US-A1- 2006 283 833
- US-A1- 2007 013 077
- US-A1- 2007 241 664
- US-A1- 2010 060 839
- US-A1- 2011 073 867
- US-A1- 2012 199 838

## Description

### BACKGROUND

### 1. Field of Disclosure

The present disclosure of invention relates to a metal wiring etchant composition, to a metal wiring formed with the etchant composition and to a method of manufacturing a display substrate. More particularly, exemplary embodiments relate to an etchant composition used for etching metal wiring layers that include copper as a major component, to a metal wiring formed by using the etchant composition and a method of manufacturing a display substrate using the etchant composition.

### 2. Description of Related Technology

Generally, flat or curved panel displays (e.g., Liquid Crystal Displays or LCD's) include a display substrate that has patterned wirings integrally formed on it for interconnecting circuitry such as thin-film transistors ("TFT's") where the latter are used as switching elements for driving corresponding pixel, units of the display device. More specifically, so-called, gate lines and data lines may be provided in different metal wiring layers as signal lines connected to respective ones of the TFTs for controlling charging and discharging of corresponding pixel electrodes. Yet more specifically, the gate lines are configured for transmitting corresponding gate driving signals and the data lines are configured for transmitting corresponding source driving signals for respective gate and source terminals of respective TFT's.

As the display area size of display apparatuses increases and also as customer's demand for display apparatuses having higher resolutions grows, the lengths of the gate lines and of the data lines becomes increased while at the same time the width of the gate and data lines tends to become decreased, and as a result electric resistance as seen from a signal providing source point to a TFT located at a far end of a gate or data line becomes undesirably increased. More specifically, an undesired resistance-capacitance ("RC") signal delay factor becomes larger. In order to reduce an associated RC signal delay problem, gate and data lines are formed to include a metal having relatively a low resistance. For example, copper or copper based alloys are metals having such a relatively low resistance. When used for forming the gate and data lines, the Cu-based materials exhibit excellent electric conductivity and have resistances much lower than say, aluminum or chrome. Furthermore, copper is relatively abundant as a natural resource. However, during mass production fabrication of display panels, Cu and Cu-based conductive layers exhibit an undesirably large opposition to being etched by chemical oxidizers, that opposition to etching being substantially higher than that of aluminum or chrome. Accordingly, in order to etch Cu-based conductive layers at practical speeds, substantially stronger (more caustic) oxidizers are required for etching such copper-based conductive layers so as to form desirably-patterned signal lines in respective metal wiring layers.

While the copper etchants that include the strong oxidizers are effective for etching the respective copper layers, they are so caustic that they easily damage underlying patterns previously formed in prior processes. One solution to the problem is to replace a conventional peroxide-based etchant that is sometimes used for wet etching of copper with an etchant including a persulfuric acid-based compound as a main etching element, the purpose of this being to reduce damaging etching of patterns previously formed in prior processes when etching the copper layer. However, such persulfuric acid-based etchants tend to be unstable when stored at a room temperature, and they are limited in terms of the maximize number of substrates that can be treated by a predetermined amount of the etchant solution.

Furthermore, when efforts for reducing the RC delay problem by increasing the thickness of the signal lines are attempted, the copper wiring formed by the conventional etchants may develop an undesirably small (more acute), base taper angle which is compensated for by increasing the size of a base portion of the wiring cross section and thereby undesirably reducing an opening ratio (aperture ratio) of the pixel areas of the display device.

It is to be understood that this background of the technology section is intended to provide useful background for understanding the here disclosed technology and as such, the technology background section may include ideas, concepts or recognitions that were not part of what was known or appreciated by those skilled in the pertinent art prior to corresponding invention dates of subject matter disclosed herein.

EP1507267, EP1933293 and US2007/241664 disclose the features of the preamble of the independent claim.

### SUMMARY

The present invention provides a combination of patterned metal wire and a substrate having the metal wire formed thereon according to the appended claims.

An etchant composition usable for patterning a copper-based layer is provided herein which has high storage stability at room temperature and which is capable of increasing a number of treated substrates per unit volume of the etchant and which is capable of desirably increasing a base taper angle of a cross section of the formed wires (e.g., a base taper angle of trapezoidal cross sections of the formed wirings).

Metal wirings that include Cu-based conductors etched by the etchant composition are also provided.

A method of manufacturing a display substrate using the etchant composition is also provided.

According to an exemplary embodiment, a patterned metal wire includes an oxide layer including indium and zinc and a copper-based layer disposed on or under the oxide layer including indium and zinc. A zinc oxide amount of the oxide layer including indium and zinc is equal to or more than 10% by weight and less than about 35% by weight.

In an embodiment, the oxide layer including indium and zinc is disposed on the copper-based layer.

In an embodiment, a thickness of the copper-based layer is between about 1,000Å to about 3*µ*m, and a thickness of the oxide layer including indium and zinc is between about 100Å to about 500Å.

In an embodiment, a thickness of the copper-based layer is between about 1*µ*m to about 3*µ*m.

In an embodiment, a zinc oxide amount of the oxide layer including indium and zinc and disposed on the copper layer is equal to or more than 10% by weight and less than about 35% by weight.

In an embodiment, a base taper angle of a cross section profile of a wire of the copper-based layer is equal to or more than about 50°, and in one species between about 60° to about 85°.

In an embodiment, the oxide layer including indium and zinc is disposed under the copper-based layer.

In an embodiment, the metal wire further includes a titanium layer disposed under the copper-based layer.

According to embodiments of the present disclosure of invention, an etchant composition may etch a single metal layer composed of copper or a copper alloy, of molybdenum, of nickel, of cobalt, of an indium-zinc oxide, of gallium-zinc oxide, zinc-aluminum oxide, indium-tin oxide, indium-gallium-zinc oxide, amorphous indium-tin oxide, copper alloy, molybdenum-nickel alloy or molybdenum-cobalt alloy, or a multiple layered variation thereof.

The etchant composition has a high storage ability at a room temperature, and may be used for a relatively large number of substrates per unit of stored etchant solution.

Furthermore, the etchant composition may prevent damage to a base substrate including glass, silicon oxide, silicon nitride or the like.

Furthermore, the etchant composition may etch a multiple layer including copper and an oxide. Thus, productivity of manufacturing processes for a display substrate may be improved.

Furthermore, a base taper angle of a wire having a substantially trapezoidal cross section and formed as part of an etched pattern may be increased so that a base thickness of the wire may be decreased. Thus, a low resistant wire may be achieved for a display substrate, and an opening ratio of a pixel may be increased.

### BRIEF DESCRIPTION OF THE DRAWINGS

The above and other features and advantages will become more apparent by describing exemplary embodiments thereof with reference to the accompanying drawings, in which:
FIGS. 1 to 10 are cross-sectional views illustrating a method of manufacturing a display substrate according to an exemplary embodiment of the present disclosure;
FIGS. 11 to 15 are scanning electron microscope (SEM) pictures showing the cross-sections of metal patterns formed by the etchant composition according to examples of the present disclosure of invention.

### DETAILED DESCRIPTION

Hereinafter, an etchant composition, a metal wire formed with use of the etchant composition and a method of manufacturing a display substrate formed using the etchant composition will be explained in detail with reference to the accompanying drawings.

### Etchant composition

An etchant composition according to an exemplary embodiment includes phosphoric acid (H₃PO₄), nitric acid (HNO₃), acetic acid (CH₃COOH), a copper-ion compound (Cu-X), a nitric salt (Y-NO3), an acetic salt (Z-CH3CO2), and a remainder of deionized water. The etchant composition may further include a fluorometallic acid. Hereinafter, each components of the etchant composition will be described in further detail.

### Phosphoric Acid

The phosphoric acid component of the etchant composition may react with copper to thereby etch a copper-based conductive layer. For example, phosphoric acid may oxidize the copper in accordance with the following reaction:

3Cu + 2H₃PO₄ → Cu₃(PO₄)₂ + 3H₂

It has been found that when the amount of phosphoric acid (H₃PO₄) is less than about 40% by weight based on the total weight of the etchant composition, the etching speed of the copper-based layer is notably reduced or the copper-based layer may not be uniformly etched. On the other hand, it has been found that when the amount of phosphoric acid is greater than about 60% by weight, the etchant composition tends to etch excessively fast, so that it is difficult to control the etching speed and/or uniformity of the copper layer that is etched by the etchant composition. Furthermore, it has been found that when the amount of phosphoric acid is greater than about 60% by weight and the etchant composition is applied to a multi-layered conductive layer including a copper layer, an undesirable undercut may be formed.

Thus, per these findings, the etchant composition of the present disclosure preferably includes between about 40% and about 70% by weight of phosphoric acid (H3PO4) based on the total weight of the etchant composition. More preferably, the amount of phosphoric acid may be between about 40% by weight and about 55% by weight based on the total weight of the etchant composition.

### Nitric acid

The nitric acid component (HNO3) in the etchant composition may react with copper in the copper-based layer to thereby etch the copper-based layer. For example, nitric acid may oxidize copper in accordance with the following:

Cu + 4HNO₃ → Cu(NO₃)₂ + 2H₂O + 2NO₂

It has been found that when an amount of nitric acid (HNO3) is less than about 1% by weight based on the total weight of the etchant composition, the etching speed of the copper layer is excessively decreased, and the copper layer is etched non-uniformly. When the copper layer is uniformly etched, an undesired stain may be shown. In contrast, it has been found that when the amount of nitric acid (HNO3) is greater than about 10% by weight, the nitric acid in combination with the included phosphoric acid (H3PO4) excessively etches the copper layer, so that it is difficult to control the etching speed of the copper layer that is being etched. Thus, it has been found that the etchant composition may preferably include between about 1% and about 10% by weight of nitric acid (HNO3) based on the total weight of the etchant composition.

### Acetic acid

Acetic acid functions as a buffer in the etchant composition so that a reaction speed to a copper layer may be controlled.

It has been found that when an amount of the acetic acid (CH3COOH) is less than about 3% by weight based on the total weight of the etchant composition, the etching speed of the copper layer is excessively increased, so that it is difficult to control the etching speed of the copper layer that is etched. On the other hand, it has been found that when an amount of acetic acid is more than about 15% by weight, the etching speed may be decreased, and an undesirable skew may be increased. Thus, it has been found that the etchant composition may preferably include between about 3% and about 15% by weight of acetic acid (CH3COOH) based on the total weight of the etchant composition.

### Copper-ion compound

The copper-ion compound (Cu-X) may prevent an over-etching phenomenon in an early stage of the etching process.

It has been found that when an amount of the copper-ion compound is less than about 0.01% by weight based on the total weight of the etchant composition, the copper layer may be over-etched in an early stage of the etching process. On the other hand, it has been found that when an amount of the copper-ion compound is more than about 0.1% by weight, the etching speed may be undesirably decreased. Thus, it has been found that the etchant composition may preferably include between about 0.01% and about 0.1% by weight of the copper-ion compound (Cu-X) based on the total weight of the etchant composition.

Examples of the copper-ion compound (Cu-X) when complexed with available water may include CuSO₄·5H₂O, CuSO₄·3H₂O, Cu(NO₃)₂·3H₂O, Cu₂P₂O₇·3H₂O and the like. These may be used each alone or in various combinations thereof.

### Nitric salt

As an etching process progresses, an amount of copper ions is increased in the etching mixture bath and the nitric acid component (HNO3) of the composition may be decomposed by the increased amount of copper ions. The included nitric salt helps to inhibit the undesired decomposition of the nitric acid (HNO3) and to thus maintain the etching speed of the etchant composition.

It has been found that when an amount of the nitric salt (Y-NO3) is less than about 1% by weight based on the total weight of the etchant composition, the etching speed may be undesirably decreased. On the other hand, it has been found that when an amount of the nitric salt is more than about 10% by weight, reduction of the nitric salt is caused thereby reducing manufacturing reliability. Thus, it has been found that the etchant composition may preferably include between about 1% and about 10% by weight of the nitric salt (Y-NO3) based on the total weight of the etchant composition, and more preferably include between about 5% and about 10% by weight of the nitric salt.

Examples of the nitric salt (Y-NO3) may include NH₄NO₃, NaNO₃, KNO₃, LiNO₃, Mg(NO₃)₂, Al(NO₃)₃, Zn(NO₃)₂, Fe(NO₃)₃, Ni(NO₃)₂, Ca(NO₃)₂ and the like. These may be used each alone or in various combinations thereof.

### Acetic salt

Acetic salt in the etchant composition may control an etching speed of a copper layer.

It has been found that when an amount of the acetic salt is less than about 1% by weight based on the total weight of the etchant composition, it is difficult to control the etching speed of the copper layer that is etched. On the other hand, it has been found that when an amount of the acetic salt is less than about 10% by weight, the copper layer is etched non-uniformly. Thus, it has been found that the etchant composition may preferably include between about 1% and about 10% by weight of the acetic salt (Z-CH3CO2) based on the total weight of the etchant composition, and more preferably between about 3% and about 5% by weight of the acetic salt.

Examples of the acetic salt (Z-CH3CO2) may include CH₃CO₂NH₄, CH₃CO₂Na, CH₃CO₂K, Mg(CH₃CO₂)₂, Ca(CH₃CO₂)₂, Al(CH₃CO₂)₃, CH₃CO₂Li and the like. These may be used each alone or in various combinations thereof. For example, the acetic salt may have a degree of purity corresponding to that of the deionized water that is used for manufacturing a semiconductor device.

### Fluorometallic acid

Fluorometallic acid in the etchant composition may increase a base taper angle of a cross section of a formed wire in an etched copper layer.

It has been found that when an amount of the fluorometallic acid is more than about 1% by weight, the copper layer is etched non-uniformly. Thus, it has been found that the etchant composition may preferably include no more than about 1% by weight of a fluorometallic acid based on the total weight of the etchant composition.

Examples of the fluorometallic acid may include H₂SiF₆, HBF₄, H₂TiF₆, H₂ZrF₆ and the like. These may be used each alone or in various combinations thereof.

### Water

The utilized water preferably consists of deionized water. For example, the water may have a degree of purity of water that is used for manufacturing of semiconductive micro-devices, and have, for instance, a specific resistance of equal to or greater than about 18 MΩ/cm. An amount of water may correspond to the remainder of the etchant composition excluding the phosphoric acid (H3PO4), the nitric acid (HNO3), the acetic acid (CH3COOH), the copper-ion compound (Cu-X), the nitric salt (Y-NO3), the acetic salt (Z-CH3CO2) and the fluorometallic acid. For example, an amount of water in the etchant composition may be between about 20% by weight to about 50% by weight.

The etchant composition may be used to etch a single layered conductive film such as one predominantly composed of a selected one of copper, molybdenum, nickel, cobalt, indium-zinc oxide, gallium-zinc oxide, zinc-aluminum oxide, indium-tin oxide, indium-gallium-zinc oxide, amorphous indium-tin oxide, copper alloy, molybdenum-nickel alloy or a molybdenum-cobalt alloy. Alternatively or additionally, the disclosed etchant composition may be used to etch a multi-layered conductive film having two or more of said conductors usable for the single layered conductive film.

It has been found that the etchant composition has a high storage ability at room temperature (about 25°C), and a predetermined volume thereof may be used for etching a greater number of substrates than can a same predetermined volume of a conventional etchant.

Furthermore, the etchant composition of the present disclosure may etch a multiple layered film including both copper and a copper oxide, and may increase a base taper angle of an etched wire so that a cross section area of the wiring may be increased without having to increase a thickness of the wiring.

Furthermore, the etchant composition may prevent damage to a base substrate including a glass, a silicon oxide, a silicon nitride or the like kind of base substrate.

### Metal wiring and method of manufacturing a display substrate

Hereinafter, a metal wiring and a method of manufacturing a display substrate according to exemplary embodiment of the present disclosure of invention will be explained more fully with reference to the accompanying drawings.

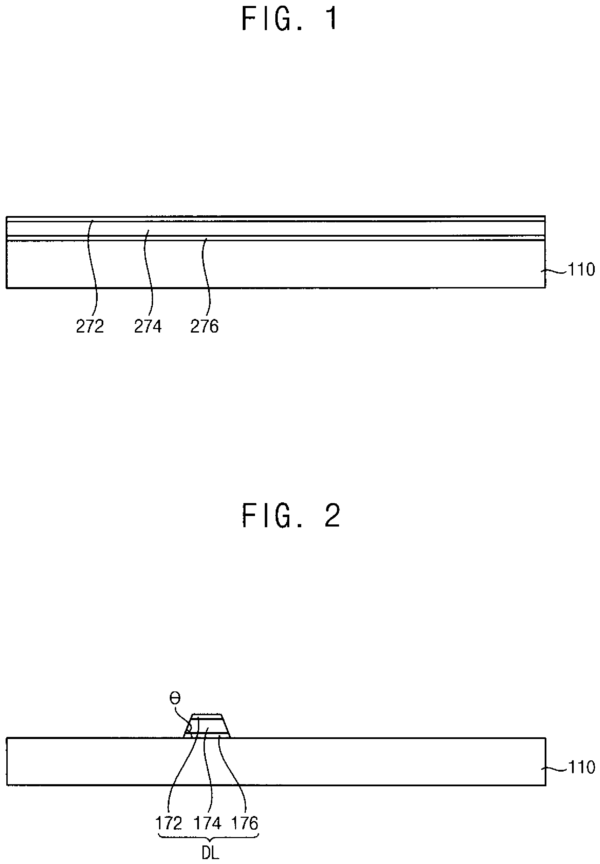

FIGs. 1 to 10 are cross-sectional views illustrating a method of manufacturing a display substrate in accordance with present disclosure. The display substrate may be a TFT array substrate that is used for a display device. A metal wiring according to an exemplary embodiment may be used for defining the gate lines or the data lines of the display device.

Referring to FIG. 1, a data wirings multi-layer 272-274 is formed on a base substrate 110. Examples of the base substrate 110 may include a glass substrate, a quartz substrate, a silicon substrate, a plastic substrate and the like.

The data wirings multi-layer includes an upper capping layer 272, a copper layer 274 and a lower capping (barrier) layer 276. For example, the upper capping layer 272 and the lower capping layer 276 may includes an oxide that blocks out-migration of the copper, and the copper layer 274 includes copper or a copper alloy. Examples of the oxide may include indium-zinc oxide, gallium-zinc oxide, zinc-aluminum oxide, indium-tin oxide, indium-gallium-zinc oxide and the like. Preferably, the oxide may include an oxide including indium and zinc such as indium-zinc oxide, indium-gallium-zinc oxide or the like.

The thickness of the copper layer 274 may be between about 1,000Å to about 3*µ*m, and preferably between about 1*µ*m to about 3*µ*m. When the thickness of the copper layer 274 is more than or equal to about 1*µ*m, resistance of a metal wiring is reduced so that a response speed of a display device may be increased. The etchant composition according to an exemplary embodiment of the present disclosure may be advantageous for etching a copper layer, of which the thickness is more than or equal to about 1*µ*m with compared to a conventional etchant composition. Particularly, the etchant composition may increase a base taper angle (θ in Fig. 2) of a cross sectional profile of an obtained conductor formed by etching a copper layer having a thickness more than or equal to about 1*µ*m, and may reduce a skew of the obtained pattern away from its planned locus.

The thickness of the upper capping layer 272 and the lower capping layer 276 may be about 100Å to about 500Å.

The upper capping layer 272 and the lower capping layer 276 preferably have Moh's hardness which is greater than that of the copper layer 274, preferably, equal to or more than about 4.0.

When the upper capping layer 272 and the lower capping layer 276 include an oxide including indium and zinc, an amount of zinc oxide may be properly adjusted for improving a profile of a metal wiring. For example, it has been found that when an amount of zinc oxide is equal to or more than about 35% by weight, side etching of the upper capping layer 272 or the lower capping layer 276 may not be uniform, or the base substrate 110 may be damaged. When an amount of zinc oxide is less than about 10% by weight, an etching ratio is excessively low so that it is difficult to perform the etching process in a practical amount of time. Thus, a zinc oxide amount in the oxide layer including indium and zinc may be preferably equal to or more than about 10% by weight and less than about 35% by weight.

The copper layer 274 may be formed through a sputtering method or the like. The upper capping layer 272 and the lower capping layer 276 may be formed through a chemical vapor deposition (CVD) method, a plasma enhanced chemical vapor deposition (PECVD) method or the like.

In another embodiment, the upper capping layer and/or the lower capping layer may be omitted. For example, the data wiring layer may have a double-layered structure including a copper layer and a titanium layer disposed under the copper layer, a double-layered structure including a copper layer and an oxide layer disposed on the copper layer and including indium and zinc, or a double-layered structure including a copper layer and an oxide layer disposed under the copper layer and including indium and zinc.

In another embodiment, the data wiring layer may have a triple-layered structure including a copper layer, an oxide layer disposed on the copper layer and including indium and zinc, and a titanium layer disposed under the copper layer, or a quadruple-layered structure including a copper layer, an oxide layer disposed on the copper layer and including indium and zinc, a titanium layer disposed under the copper layer, and an oxide layer disposed under the titanium layer and including indium and zinc.

Referring to FIG. 2, the data wiring layer is patterned by an etchant composition in accordance with the present disclosure to form a data line DL. For example, a photoresist composition is coated on the upper capping layer 272 of Fig. 1 to form a photoresist pattern having a shape corresponding to that desired for the data line DL. The upper capping layer 272, the copper layer 274 and the lower capping layer 276, which are uncovered by the photoresist pattern, are sequentially etched to form the data line DL.

The upper capping layer 272, the copper layer 274 and the lower capping layer 276 are etched by a same etchant composition in a same process. Thus, the data line DL may have relatively a larger base taper angle than would be producible with a conventional copper etchant. Thus, an opening ratio (aperture ratio) of a display device may be increased because the cross sectional area of the formed data line is increased due to the increased base taper angle and thus the dimension of the base portion of the trapezoidal or alike wring cross section does not have to be increased to compensate for a more acute (further below 90 degrees) base taper angle. The base taper angle may be defined as an angle formed by a lower (base) surface and a sidewall surface of the formed wire cross section. For example, by using the etchant compositions disclosed herein, a taper angle θ of a copper-based wiring layer or more specifically, that of a patterned data line DL may be made equal to or more than about 50°, preferably between about 60° to about 85°. As a result, a base dimension of the formed wire cross section may be reduced and an aperture ratio associated with light-passing openings of the display substrate may be desirably increased.

The utilized etchant composition may be provided through a spraying method, a dipping method or the like. The etchant composition may include phosphoric acid (H3PO4), nitric acid (HNO3), acetic acid (CH3COOH), a copper ion salt (Cu-X), a nitric salt (Y-NO3), an acetic salt (Z-CH3CO2) and deionized (DI) water in accordance with the above provided specifications. When the data metal layer includes a titanium layer, the etchant composition may further include a fluorometallic acid in accordance with the above provided specifications. Alternatively, the titanium layer may be etched by an additional etchant composition different from the etchant composition specified above. The separate etchant composition for etching the titanium layer may include a fluoride and water. Examples of the fluoride may include HF, NH₄F, NH₄HF₂ and the like.

The utilized etchant composition for the copper portion may be substantially the same as the previously explained etchant compositions according to the above specified embodiments. Thus, any duplicative explanation will be omitted.

The patterned data line DL includes an upper capping layer 172, a lower capping layer 176 and a metal layer 174 disposed between the upper capping layer 172 and the lower capping layer 176. The base substrate 110 having the data line DL or another such copper-based metal wiring layer on it may be cleaned by a brush after the data wiring layer is formed or after the data wiring layer is etched.

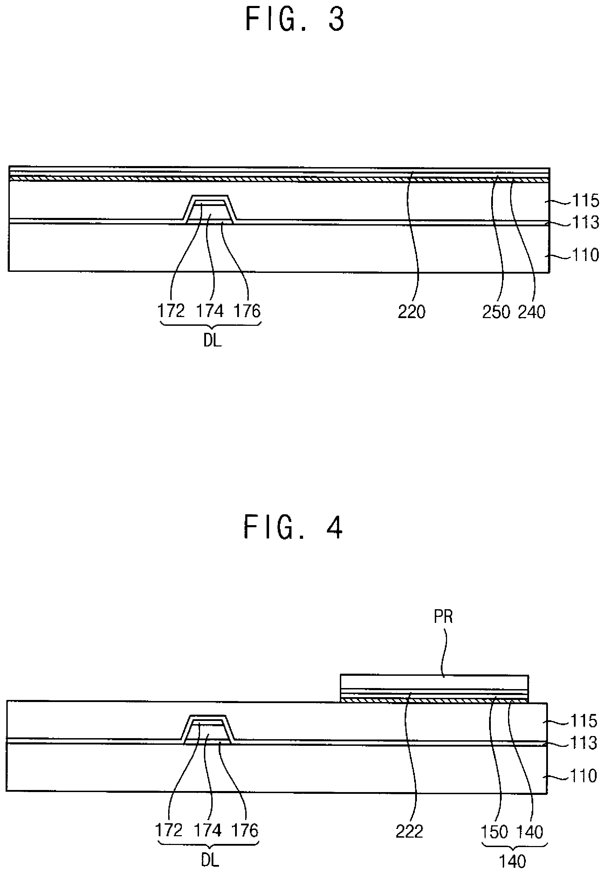

Referring to FIG. 3, a data lines insulating layer 113 is formed to cover the patterned data lines DL (one shown). Next, a first planarizing layer 115 is disposed on the data insulation layer 113. Then, a light-blocking layer 240 (e.g., black matrix forming layer) is disposed on the first planarizing layer 115. Thereafter, a buffer layer 250 is disposed on the light-blocking layer 240, and a semiconductive oxide layer 220 is disposed on the buffer layer 250. Thus the illustrated layers of Fig. 3 are sequentially formed on the base substrate 110. Examples of a material that may be used for the data insulation layer 113 may include a silicon nitride, a silicon oxide, an aluminum oxide and the like. The thickness of the data insulation layer 113 may be between about 500Å to about 2,000Å.

After formation of the insulation layer 113, an organic planarization composition such as one including a binder resin is coated on the data insulation layer 113. Examples of the binder resin may include an acryl resin, a phenol resin and the like, which are highly thermo-resistive. The planarization composition may be coated through a spin-coating method. The composition may be cured by heat or UV to form the first planarizing layer 115. The first planarizing layer 115 preferably has a large thickness enough to planarize an upper surface of the substrate.

The light-blocking layer 240 may include a metal, an alloy, an insulating inorganic material, an organic material or the like. Preferably, examples of the material that may be used for the light-blocking layer 240 may include a silicon oxide, a silicon-germanium alloy, germanium, a titanium oxide and the like. More preferably, the light-blocking layer 240 includes a silicon-germanium (SiGe) alloy.

The thickness of the light-blocking layer 240 may be between about 100Å to about 2,000Å, and preferably between about 600Å to about 2,000Å. When the thickness of the light-blocking layer 240 is equal to or more than about 600Å, the light-blocking layer 240 may have relatively a high optical density.

Examples of a material that may be used for the buffer layer 250 may include an insulation oxide such as a silicon oxide, an aluminum oxide, a hafnium oxide, a yttrium oxide or the like. The thickness of the buffer layer 250 may be between about 500Å to about 1*µ*m.

The semiconductive oxide layer 220 is formed on the buffer layer 250. The semiconductive oxide layer 220 may include a semiconductive metal oxide. For example, the semiconductive metal oxide may include an oxide of zinc, of indium, of gallium, of tin, of titanium, of phosphor or various combinations thereof. Particularly, the semiconductive metal oxide may include zinc oxide (ZnO), zinc tin oxide (ZTO), zinc indium oxide (ZInO), indium oxide (InO), titanium oxide (TiO), indium gallium zinc oxide (IGZO), indium zinc tin oxide (IZTO) or the like.

The semiconductive oxide layer 220 may be formed through a chemical vapor deposition (CVD) process, a plasma enhanced chemical vapor deposition (PECVD) process, a solution coating process, or the like.

Referring to FIG. 4, the semiconductive oxide layer 220 is patterned to form a semiconductive oxide patterned region 222. For example, after a photoresist pattern PR is formed on the semiconductive oxide layer 220, an exposed portion of the semiconductive oxide layer 220 is etched by using the photoresist pattern PR as a mask. Thus, an upper surface of the buffer layer 250 is partially exposed.

Thereafter, the buffer layer 250 and the light-blocking layer 240 are sequentially etched by using the photoresist pattern PR as a mask to form a buffer pattern 150 and a light-blocking pattern 140. Then, the photoresist pattern PR is removed. As a result, the semiconductive oxide patterned region 222, the buffer pattern 150 and the light-blocking pattern 140 have substantially a same size and a same shape when seen in a top plan view.

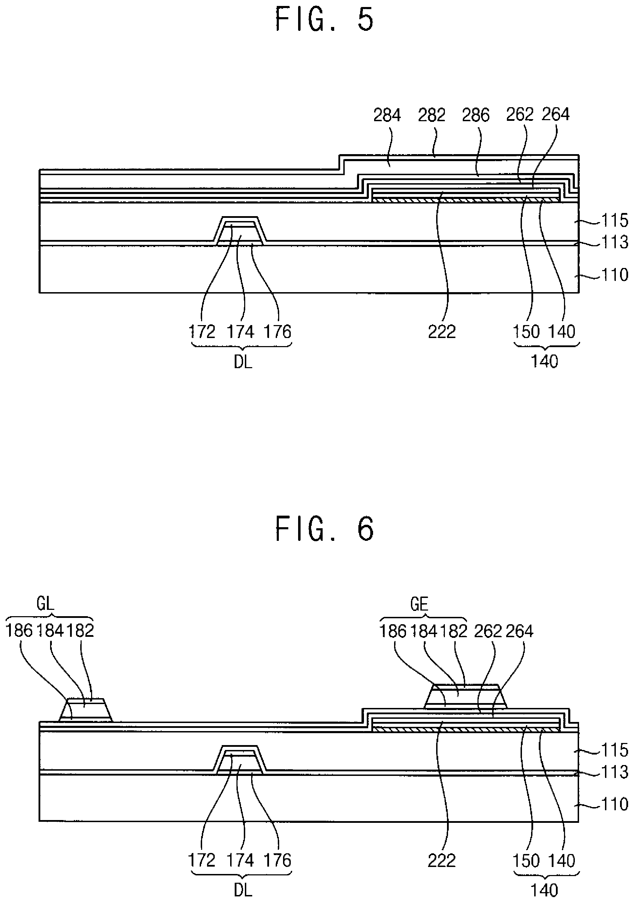

Referring to FIG. 5, on top of the structure of Fig. 4, there are formed in recited order, a gate insulation layer 262-264 and a gate metal layer 282-286.

The gate insulation layer includes an upper gate insulation layer 262 and a lower gate insulation layer 264. The lower gate insulation layer 264 contacts the semiconductive oxide pattern 222. Thus, the lower gate insulation layer 264 preferably includes a material have relatively a small amount of hydrogen. For example, the lower gate insulation layer 264 may include an insulation oxide such as a silicon oxide, an aluminum oxide, a hafnium oxide, a yttrium oxide or the like, and the thickness of the lower gate insulation layer 264 may be between about 500Å to about 3,000Å. The upper gate insulation layer 262 is formed on the lower gate insulation layer 264. The upper gate insulation layer 262 may include a silicon nitride or the like, and the thickness of the upper gate insulation layer 262 may be between about 500Å to about 2,000Å.

In one embodiment, the gate insulation layer has a multiple-layered structure as the above. Alternatively, the gate insulation layer may have a single-layered structure including an insulation oxide such as a silicon oxide.

The gate metal layer includes an upper capping layer 282, a metal layer 284 and a lower capping layer 286. For example, the upper capping layer 282 and the lower capping layer 286 may include an oxide such as IZO, and the metal layer 284 may include a metal such as copper. The gate lines metal layer may have substantially a same constitution as the data lines metal layer. Thus, any duplicative explanation will be omitted. In another embodiment, the gate lines metal layer may have a different structure from the data lines metal layer. For example, the gate lines metal layer may have a double-layered structure including a copper-based layer and a titanium-based barrier layer disposed under the copper-based layer.

Referring to FIG. 6, the gate lines metal layer is patterned to form respective gate electrodes GE integrally branching from corresponding gate lines GL (only one pair shown).

For example, a photoresist composition is coated on the upper capping layer 282 to form a photoresist pattern having a shape corresponding to the gate line GL and the gate electrode GE. Thereafter, the upper capping layer 282, the metal layer 284 and the lower capping layer 286, which are not covered by the photoresist pattern, are sequentially etched to form the gate line GL and the gate electrode GE.

Preferably, the upper capping layer 282, the metal layer 284 and the lower capping layer 286 are etched in a same process using a same etchant composition. Thus, the gate line GL may have relatively a large base taper angle so that an opening ratio of a display substrate is desirably increased.

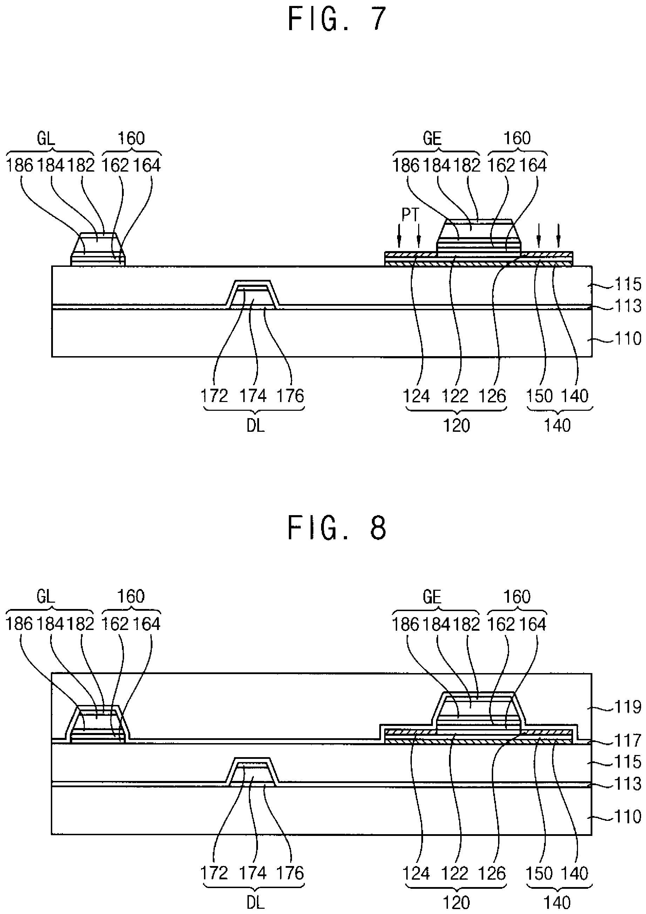

Referring to FIG. 7, the upper gate insulation layer 262 and the lower gate insulation layer 264 are patterned by using the gate electrode GE and the gate line GE as a mask to form a gate insulation pattern 160. Thus, the gate insulation pattern 160 may have substantially a same size and a same shape as the gate line GE and the gate electrode GE.

In the process of patterning the gate insulation layer, the semiconductive oxide pattern 222 is exposed. However, the semiconductive oxide 222 includes a different material from the gate insulation layer. Thus, the means (e.g., etchant) used for patterning the gate insulation layer has an etching selectivity with respect to the gate insulation layer, and the semiconductive oxide pattern 222 is not substantially etched when the gate insulation layer is etched.

Thereafter, a channel 122, a source electrode 124 and a drain electrode 126 are formed from the semiconductive oxide pattern 222. Particularly, a portion of the semiconductive oxide pattern 222, which is not covered by the gate electrode GE and the gate insulation pattern 160, is turned into the source electrode 124 and the drain electrode 126.

For example, the semiconductive oxide pattern 222 may be plasma-treated to form the source electrode 124 and the drain electrode 126. For example, an exposed portion of the semiconductive oxide pattern 222 is subjected to a plasma gas PT containing H₂, He, PH₃, NH₃, SiH₄, CH₄, C₂H₂, B₂H₆, CO₂, GeH₄, H₂Se, H₂S, Ar, N₂, N₂O, CHF₃ or the like. Accordingly, at least a portion of a semiconductor material included in the semiconductive oxide pattern 222 is reduced to form a metallic conductor. As a result, the reduced portion of the semiconductive oxide pattern 222 forms the source electrode 124 and the drain electrode 126, and a portion of the semiconductive oxide pattern 222, which is covered by the gate electrode GE and the gate insulation pattern 160, remains unchanged so as to function as the channel region 122 of the formed transistor.

Alternatively, the semiconductive oxide pattern 222 may be heated in an atmosphere of a reducing gas or may be ion-implanted (e.g., heavily doped) to form the more conductive source electrode 124 and drain electrode 126.

Referring to FIG. 8, a passivation layer 117 is formed to cover the gate electrode GE, the gate line GL, the source electrode 124, the drain electrode 126, and the first planarizing layer 115. Then, a second planarizing layer 119 is formed on the passivation layer 117.

The passivation layer 117 may include a silicon nitride, a silicon oxide, an aluminum oxide or the like. The second planarizing layer 119 planarizes a surface of the substrate. A photoresist composition may be spin-coated on the passivation layer 117 to form the second planarizing layer 119.

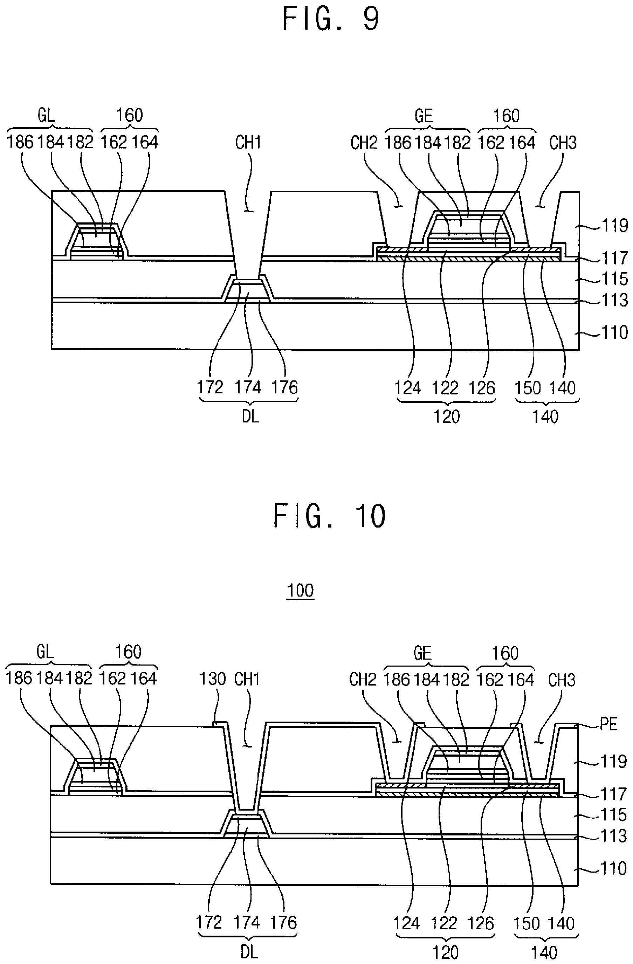

Referring to FIG. 9, the data insulation layer 113, the first planarizing layer 115, the passivation layer 117 and the second planarizing layer 119 are patterned to form a plurality of contact holes as illustrated.

For example, the data insulation layer 113, the first planarizing layer 115 and the passivation layer 117 and the second planarizing layer 119 are patterned to form a first contact hole CH1 exposing a portion of the data line DL, and the passivation layer 117 and the second planarizing layer 119 are patterned to form a second contact hole CH2 exposing a portion of the source electrode 124, and a third contact hole CH3 exposing a portion of the drain electrode 126.

Particularly, the second planarizing layer 119 (which can be a photoresist) is exposed to a masked curing light. Thereafter, a developer is applied to the second planarizing layer 119 to remove the appropriate light-exposed portion or a non light-exposed portion (depending on if the PR is a positive or negative development kind) so that the second planarizing layer 119 is patterned. The passivation layer 117, the data insulation layer 113 and the first planarizing layer 115 are etched by using the second planarizing layer 119 as a mask to form the first to third contact holes CH1, CH2 and CH3.

Referring to FIG. 10, a transparent conductive layer is formed on the patterned second planarizing layer 119. Examples of a material that may be used for the transparent conductive layer may include IZO, ITO and the like.

The transparent conductive layer is patterned to form a connection electrode 130 and a pixel electrode PE. The connection electrode 130 contacts the data line DL through the first contact hole CH1, and contacts the source electrode 124 through the second contact hole CH2. The pixel electrode PE contacts the drain electrode 124 through the third contact hole CH3.

According to the described embodiment, a signal lines wiring layer having a multiple-layered structure may be etched by a same etchant composition to improve productivity. Furthermore, a base taper angle of the cross sections of the signal wires is improved to achieve a lower resistance wire having a relatively large cross sectional area.

Hereinafter, effects of etchant compositions according to exemplary embodiments will be explained with reference to experimental results of examples and comparative examples.

### Preparation of an Etchant composition

Etchant compositions including phosphoric acid (H3PO4), nitric acid (HNO3), acetic acid (CH3COOH), Cu(NO₃)₂·3H₂O as a copper-ion compound, H₂TiF₆ as a fluorometallic acid, KNO₃ as a nitric salt (Y-NO3), CH₃CO₂NH₄ as an acetic salt, and DI water were prepared according to the following Table 1.

**Table 1**

| | Phosph oric acid (% by weight) | Nitric acid (% by weight) | Acetic acid (% by weight) | Copper-ion compound (% by weight) | Fluoromet allic acid (% by weight) | Nitric salt (% by weight ) | Acetic salt (% by weight) |
|---|---|---|---|---|---|---|---|
| Example 1 | 59 | 5 | 10 | 0.05 | 0.3 | 7 | 4 |
| Example 2 | 50 | 5 | 10 | 0.05 | 0.3 | 4 | 4 |
| Example 3 | 50 | 7 | 10 | 0.05 | 1 | 7 | 4 |
| Example 4 | 50 | 4 | 10 | 0.05 | 0.3 | 7 | 4 |
| Example 5 | 50 | 5 | 10 | 0.05 | 0.3 | 7 | 4 |
| Example 6 | 50 | 5 | 10 | 0.05 | 0.3 | 7 | 7 |
| Example 7 | 50 | 5 | 10 | 0.01 | 0.3 | 7 | 4 |
| Example 8 | 50 | 5 | 10 | 0.05 | 0 | 7 | 4 |

### Experiment 1 for Evaluating Etching Properties of the Etchant compositions

Samples including a titanium layer of about 300 Å, a copper layer of about 30,000 Å and a photoresist pattern, were sequentially deposited on a glass substrate. The etchant compositions of Examples 1 to 8 of Table 1 were sprayed onto each of the samples and used to over-etch the copper layer by 60% with respect to a time required for end point detection (EPD) and to over-etch the titanium layer by 60% with respect to a time required for EPD. Etching speeds to each of the samples were measured, and CD skews and taper angles were measured by using scanning electron microscopy (SEM) pictures. Thus obtained results are shown by the following Table 2. Hereinafter, CD skew is defined as a distance between an end (sidewall) of the photoresist pattern and an end (sidewall) of the etched copper layer. In Table 2, the double circle symbol, ⊚ represents a CD skew between about 0.7*µ*m to about 1.3*µ*m and an etching speed of about 450 Å/sec to about 550 Å/sec. The single circle symbol o represents a CD skew between about 0.4*µ*m to about 0.7*µ*m or about 1.3*µ*m to about 1.6*µ*m and an etching speed of about 400 Å/sec to about 450 Å/sec or about 550 Å/sec to about 600 Å/sec. The triangle symbol Δ represents a CD skew no more than about 0.4*µ*m or no less than about 1.6*µ*m, and an etching speed no more than about 400 Å/sec or no less than about 600 Å/sec.

**Table 2**

| | Etching speed | CD skew | Taper angle (°) |
|---|---|---|---|
| Example 1 | ○ | Δ | 80 |
| Example 2 | ⊚ | ⊚ | 47 |
| Example 3 | ⊚ | Δ | 75 |
| Example 4 | ○ | Δ | 56 |
| Example 5 | ⊚ | ⊚ | 68 |
| Example 6 | Δ | Δ | - |
| Example 7 | ⊚ | ⊚ | 68 |
| Example 8 | ⊚ | ⊚ | 68 |

Referring to Table 2, it can be noted that the sample obtained by using the etchant composition of Example 5 including about 50% by weight of phosphoric acid, about 7 % by weighty of the nitric salt, about 5% by weight of nitric acid and about 4% by weight of the acetic salt has more preferable properties in comparison to the samples obtained by using the etchant compositions of: (a) Example 1 including about 59% by weight of phosphoric acid, (b) Example 2 including about 4% by weight of the nitric salt, (c) Example 4 including about 4% by weight of nitric acid and (d) Example 6 including about 7% by weight of the acetic acid.

### Experiment 2 for Evaluating Etching Properties of the Etchant compositions

The etchant composition of Example 5 was kept for a predetermined storing time at about 25°C. Thereafter, the etchant composition was sprayed to each of samples including a titanium layer of about 300 Å, a copper layer of about 30,000 Å and a photoresist pattern, which were sequentially deposited on a glass substrate, to over-etch the copper layer by 60% with respect to a time required for EPD and to over-etch the titanium layer by 60% with respect to a time required for EPD. The time for EPD to each of the samples was measured, and CD skews and taper angles were measured by using SEM pictures. Thus obtained results are shown by the following Table 3.

**Table 3**

| Storing time | 0 day | 1 week | 2 weeks | 3 weeks | 8 weeks | 12 weeks |
|---|---|---|---|---|---|---|
| EPD (sec) | 56.9 | 59.4 | 59.3 | 58.9 | 58.8 | 59.1 |
| CD skew (*µ*m) | 0.773 | 0.750 | 0.843 | 0.820 | 0.820 | 0.843 |
| Taper angle (°) | 62 | 62 | 63 | 63 | 67 | 64 |

Referring to Table 3, even if the storing time of the etchant composition of Example 5 is increased, the etching speed, the CD skew and the taper angle are not greatly changed. Thus, it can be noted that the etchant composition has a good storing stability.

### Experiment 3 for Evaluating Etching Properties of the Etchant compositions

With a copper ion concentration of the etchant composition of Example 5 being changed, the etchant composition was sprayed to each of samples including a titanium layer of about 300 Å, a copper layer of about 30,000 Å and a photoresist pattern, which were sequentially deposited on a glass substrate, to over-etch the copper layer by 30% with respect to a time required for EPD and to over-etch the titanium layer by 30% with respect to a time required for EPD. The time for EPD to each of the samples was measured, and CD skews and taper angles were measured by using SEM pictures. Thus obtained results are shown by the following Table 4.

**Table 4**

| Copper ion concentration (ppm) | 0 | 2,000 | 4,000 | 6,000 | 8,000 | 10,000 | 12,000 |
|---|---|---|---|---|---|---|---|
| EPD (sec) | 58.7 | 62.2 | 61.9 | 65.0 | 72.1 | 78.4 | 78.3 |
| CD skew (*µ*m) | 0.398 | 0.375 | 0.328 | 0.351 | 0.398 | 0.398 | 0.469 |
| Taper angle (°) | 62 | 62 | 61 | 64 | 62 | 62 | 62 |

Referring to Table 4, even if the copper ion concentration in the etchant composition is increased, variation of the etching speed, the CD skew and the taper angle is not large. Thus, it can be noted that the etchant composition has an improved reliability for reusing.

### Experiment 4 for Evaluating Etching Properties of the Etchant compositions

A Sample 1 including an IZO layer of about 300 Å, a copper layer of about 5,000 Å, an IZO layer of about 300 Å and a photoresist pattern, which were sequentially deposited on a glass substrate, a Sample 2 including an IZO layer of about 300 Å, a copper layer of about 10,000 Å, an IZO layer of about 300 Å and a photoresist pattern, which were sequentially deposited on a glass substrate, and a Sample 3 including an IZO layer of about 300 Å, a copper layer of about 30,000 Å, an IZO layer of about 300 Å and a photoresist pattern, which were sequentially deposited on a glass substrate, were prepared.

The etchant composition of Example 8 was sprayed to each of Samples 1 to 3 to over-etch the IZO layer and the copper layer by 60% with respect to a time required for EPD. Etching speeds to each of the Samples were measured, and CD skews and taper angles were measured by using SEM pictures. Thus obtained results are shown by the following Table 5.

**Table 5**

| Thickness of copper layer (Å) | Etching speed (*µ*m/min) | CD skew | Taper angle |
|---|---|---|---|
| 5,000 | 2.7 | 0.97 | 81 |
| 10,000 | 2.7 | 1.14 | 81 |
| 30,000 | 2.7 | 1.34 | 70 |

### Experiment 5 for Evaluating Etching Properties of the Etchant compositions

Samples including an IZO layer of about 300 Å and a photoresist pattern, which were sequentially deposited on a glass substrate, were prepared. Each IZO layer of the samples has different zinc oxide amounts.

The etchant composition of Example 8 was sprayed to each of the samples to over-etch the IZO layer by 60% with respect to a time required for EPD. Etching speeds to each of the samples were measured, and obtained patterns were observed by using SEM pictures. Thus obtained results are shown by the following Table 6. In Table 6, the etched state was evaluated with respect to uniformity of side surface etching, damage to a base substrate, etc., and ○ represents "very good", Δ represents "good" and X represents "bad".

**Table 6**

| Zinc oxide amount (% by weight) | 10 | 15 | 20 | 25 | 35 | 45 | 60 | 80 | 90 |
|---|---|---|---|---|---|---|---|---|---|
| Etching speed (Å/sec) | 28.4 | 37.4 | 45.5 | 72.9 | 66.4 | 92.2 | 201.4 | 1,143 | 4,800 |
| Etched state | ○ | ○ | ○ | Δ | X | X | X | X | X |

Referring to Table 6, when the zinc oxide amount was equal to or more than about 60% by weight, an etching speed was excessively increased, and when the zinc oxide amount was equal to or more than about 35% by weight, the etched state was deteriorated. Thus, it can be noted that the etchant composition may be preferable for etching an IZO layer having a zinc oxide amount less than about 35% by weight.

### Experiment 6 for Evaluating Etching Properties of the Etchant compositions

Samples including an IZO layer of about 300 Å, a copper layer of about 5,000 Å, an IZO layer of about 300 Å and a photoresist pattern, which were sequentially deposited on a glass substrate, were prepared and etched by the etchant composition of Example 8. Etched states of the samples were observed.

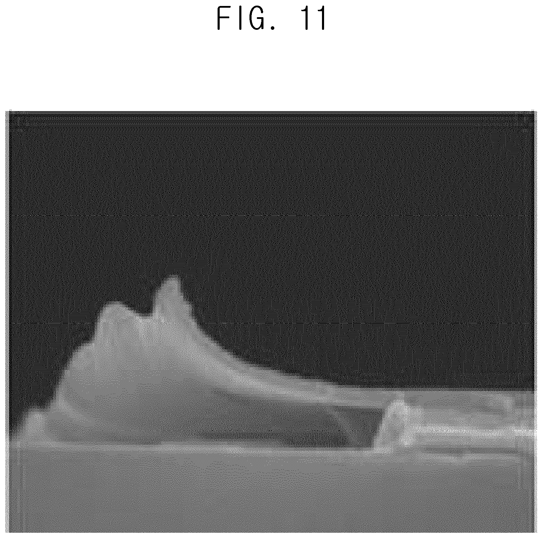

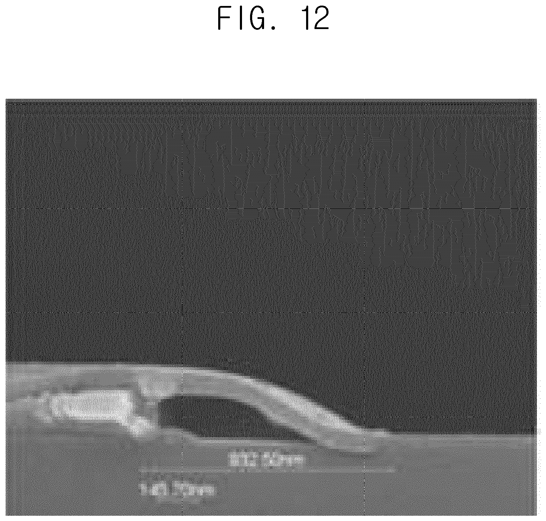

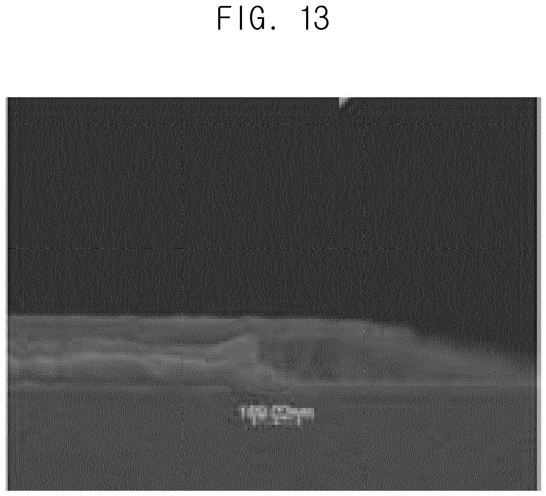

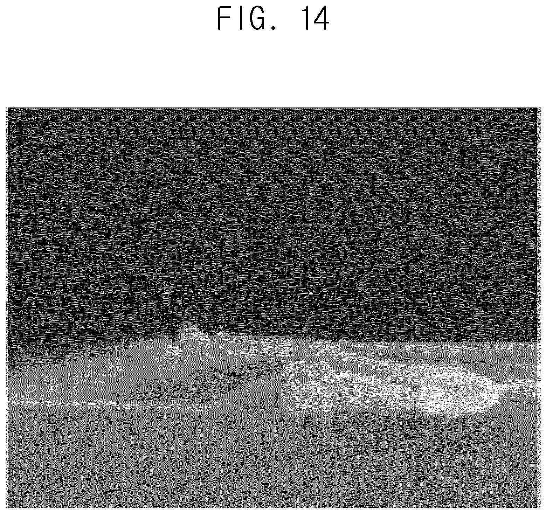

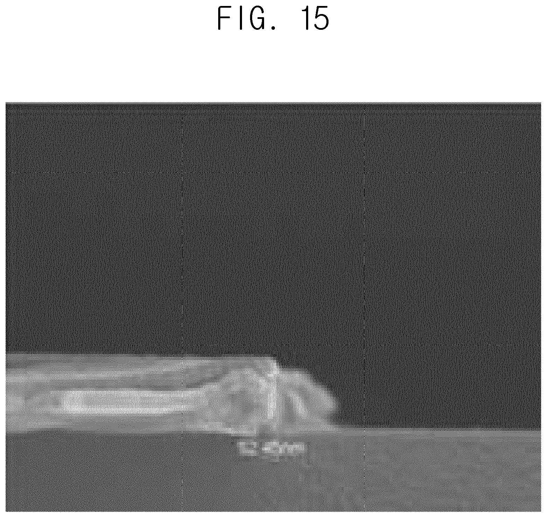

FIG. 11 is a SEM picture of the sample including an IZO layer having the zinc oxide amount of about 5% by weight and obtained by over-etching by 50% with respect to EPD. FIG. 12 is a SEM picture of the sample including an IZO layer having the zinc oxide amount of about 10% by weight and obtained by over-etching by 50% with respect to EPD. FIG. 13 is a SEM picture of the sample including an IZO layer having the zinc oxide amount of about 25% by weight and obtained by over-etching by 50% with respect to EPD. FIG. 14 is a SEM picture of the sample including an IZO layer having the zinc oxide amount of about 10% by weight and obtained by over-etching by 100% with respect to EPD. FIG. 15 is a SEM picture of the sample including an IZO layer having the zinc oxide amount of about 25% by weight and obtained by over-etching by 150% with respect to EPD.

Referring to FIGs. 11 to 15, as the zinc oxide amount in the IZO layer is increased, a protrusion length of an upper IZO layer is reduced. Furthermore, even if the zinc oxide amount in the IZO layer is increased, as the etching time is increased, a protrusion length of an upper IZO layer is reduced.

Thus, it can be noted from the cross sectional views that a profile of a wire may be improved by adjusting the zinc oxide amount in the IZO layer or the etching time.

The foregoing is illustrative of the present teachings and is not to be construed as limiting thereof. Although a few exemplary embodiments have been described, those skilled in the art will readily appreciate from the foregoing that many modifications are possible in the exemplary embodiments without materially departing from the novel teachings and advantages of the present disclosure of invention. Accordingly, all such modifications are intended to be included within the scope of the present teachings. In the claims, means-plus-function clauses are intended to cover the structures described herein as performing the recited function and not only structural equivalents but also functionally equivalent structures.

## Claims

1. A combination of patterned metal wire and a substrate (110) having the metal wire formed thereon, the metal wire comprising:
an oxide layer including indium and zinc; and
a copper-based layer (174, 274, 284) disposed on or under the oxide layer including indium and zinc, **characterized in that** a zinc oxide (ZnO) amount of the oxide layer including indium and zinc is equal to or more than 15% by weight and less than about 35% by weight.

2. The combination of claim 1, wherein a thickness of the copper-based layer (174, 274, 284) is between about 1,000Å to about 3*µ*m, and a thickness of the oxide layer including indium and zinc is between about 100 Å to about 500 Å.

3. The combination of claim 1, wherein a thickness of the copper-based layer (174, 274, 284) is between about 1*µ*m to about 3*µ*m.

4. The combination of claim 1, wherein the oxide layer including indium and zinc is disposed on the copper-based layer (174, 274, 284).

5. The combination of claim 1, wherein the copper-based layer (174, 274, 284) has a substantially trapezoidal cross sectional profile, and the base taper angle of the cross sectional profile of the copper-based layer (174, 274, 284) is substantially more than 50°.

6. The combination of claim 5, wherein the base taper angle of the copper-based layer (174, 274, 284) is between about 60° to about 85°.

7. The combination of claim 1, wherein the oxide layer including indium and zinc is disposed under the copper-based layer (174, 274, 284).

8. The combination of claim 7, further comprising a semiconductive oxide layer disposed under the oxide layer including indium and zinc, the semiconductive oxide layer (220) including indium and zinc.

9. The combination of claim 1, further comprising a titanium layer disposed under the copper-based layer (174, 274, 284).

10. The combination of one of claims 1 to 9, comprising an upper capping layer (272, 282) disposed on the copper-based layer (174, 274, 284) and a lower capping layer (276, 286) disposed under the copper-based layer (174, 274, 284), both capping layers (272, 282, 276, 286) including the oxide layer including indium and zinc.

11. The combination of one of claims 1 to 10, wherein the zinc oxide (ZnO) amount of the oxide layer including indium and zinc is more than 20% by weight.

12. The combination of one of claims 1 to 11, wherein the copper-based layer (174, 274, 284) consists of copper.

## Patentansprüche

1. Kombination aus strukturiertem Metalldraht und einem Substrat (110) mit dem darauf gebildeten Metalldraht, wobei der Metalldraht Folgendes umfasst:
eine Oxidschicht, die Indium und Zink enthält; und
eine kupferbasierte Schicht (174, 274, 284), die auf oder unter der Oxidschicht, die Indium und Zink enthält, angeordnet ist, **dadurch gekennzeichnet, dass** eine Menge an Zinkoxid (ZnO) der Oxidschicht, die Indium und Zink enthält, gleich oder größer als 15 Gew.-% und kleiner als etwa 35 Gew.-% ist.

2. Kombination nach Anspruch 1, wobei eine Dicke der kupferbasierten Schicht (174, 274, 284) zwischen etwa 1.000 Å bis etwa 3 µm und eine Dicke der Oxidschicht, die Indium und Zink enthält, zwischen etwa 100 Å bis etwa 500 Å beträgt.

3. Kombination nach Anspruch 1, wobei eine Dicke der kupferbasierten Schicht (174, 274, 284) zwischen etwa 1 µm bis etwa 3 µm beträgt.

4. Kombination nach Anspruch 1, wobei die Oxidschicht, die Indium und Zink enthält, auf der kupferbasierten Schicht (174, 274, 284) angeordnet ist.

5. Kombination nach Anspruch 1, wobei die kupferbasierte Schicht (174, 274, 284) ein im Wesentlichen trapezförmiges Querschnittsprofil aufweist, und der Basisverjüngungswinkel des Querschnittprofils der kupferbasierten Schicht (174, 274, 284) im Wesentlichen größer als 50° ist.

6. Kombination nach Anspruch 5, wobei der Basisverjüngungswinkel der kupferbasierten Schicht (174, 274, 284) zwischen etwa 60° bis etwa 85° beträgt.

7. Kombination nach Anspruch 1, wobei die Oxidschicht, die Indium und Zink enthält, unter der kupferbasierten Schicht (174, 274, 284) angeordnet ist.

8. Kombination nach Anspruch 7, ferner eine halbleitende Oxidschicht umfassend, die unter der Oxidschicht, die Indium und Zink enthält, angeordnet ist, wobei die halbleitende Oxidschicht (220) Indium und Zink enthält.

9. Kombination nach Anspruch 1, ferner eine Titanschicht umfassend, die unter der kupferbasierten Schicht (174, 274, 284) angeordnet ist.

10. Kombination nach einem der Ansprüche 1 bis 9, eine obere Deckschicht (272, 282), die auf der kupferbasierten Schicht (174, 274, 284) angeordnet ist, und eine untere Deckschicht (276, 286), die unter der kupferbasierten Schicht (174, 274, 284) angeordnet ist, umfassend, wobei beide Deckschichten (272, 282, 276, 286) die Oxidschicht, die Indium und Zink enthält, enthalten.

11. Kombination nach einem der Ansprüche 1 bis 10, wobei die Menge an Zinkoxid (ZnO) der Oxidschicht, die Indium und Zink enthält, größer als 20 Gew.-% ist.

12. Kombination nach einem der Ansprüche 1 bis 11, wobei die kupferbasierte Schicht (174, 274, 284) aus Kupfer besteht.

## Revendications

1. Combinaison d'un fil de métal à motifs et d'un substrat (110) sur lequel est formé le fil de métal, le fil de métal comprenant :
une couche d'oxyde comportant de l'indium et du zinc; et
une couche à base de cuivre (174, 274, 284) disposée sur ou sous la couche d'oxyde comportant de l'indium et du zinc, **caractérisée en ce qu'**une quantité d'oxyde de zinc (ZnO) de la couche d'oxyde comportant de l'indium et du zinc est égale ou supérieure à 15 % en poids et inférieure à environ 35 % en poids.

2. Combinaison selon la revendication 1, dans laquelle une épaisseur de la couche à base de cuivre (174, 274, 284) est entre environ 1 000 Å et environ 3 µm, et une épaisseur de la couche d'oxyde comportant de l'indium et du zinc est entre environ 100 Å et environ 500 Å.

3. Combinaison selon la revendication 1, dans laquelle une épaisseur de la couche à base de cuivre (174, 274, 284) est entre environ 1 µm et environ 3 µm.

4. Combinaison selon la revendication 1, dans laquelle la couche d'oxyde comportant de l'indium et du zinc est disposée sur la couche à base de cuivre (174, 274, 284).

5. Combinaison selon la revendication 1, dans laquelle la couche à base de cuivre (174, 274, 284) a un profil en coupe sensiblement trapézoïdal, et l'angle du cône de base du profil en coupe de la couche à base de cuivre (174, 274, 284) est sensiblement supérieur à 50°.

6. Combinaison selon la revendication 5, dans laquelle l'angle du cône de base de la couche à base de cuivre (174, 274, 284) est entre environ 60° et environ 85°.

7. Combinaison selon la revendication 1, dans laquelle la couche d'oxyde comportant de l'indium et du zinc est disposée sous la couche à base de cuivre (174, 274, 284).

8. Combinaison selon la revendication 7, comprenant en outre une couche d'oxyde semi-conductrice disposée sous la couche d'oxyde comportant de l'indium et du zinc, la couche d'oxyde semi-conductrice (220) comportant de l'indium et du zinc.

9. Combinaison selon la revendication 1, comprenant en outre une couche de titane disposée sous la couche à base de cuivre (174, 274, 284).

10. Combinaison selon l'une des revendications 1 à 9, comprenant une couche de coiffe supérieure (272, 282) disposée sur la couche à base de cuivre (174, 274, 284) et une couche de coiffe inférieure (276, 286) disposée sous la couche à base de cuivre (174, 274, 284), les deux couches de coiffe (272, 282, 276, 286) comportant la couche d'oxyde comportant de l'indium et du zinc.

11. Combinaison selon l'une des revendications 1 à 10, dans laquelle la quantité d'oxyde de zinc (ZnO) de la couche d'oxyde comportant de l'indium et du zinc est de plus de 20 % en poids.

12. Combinaison selon l'une des revendications 1 à 11, dans laquelle la couche à base de cuivre (174, 274, 284) consiste en du cuivre.
